(19) Europäisches Patentamt / European Patent Office / Office européen des brevets

(11) **EP 4 203 206 A1**

(12) **EUROPEAN PATENT APPLICATION**

(43) Date of publication:
**28.06.2023 Bulletin 2023/26**

(21) Application number: **21216871.0**

(22) Date of filing: **22.12.2021**

(51) International Patent Classification (IPC):
**H01S 3/082** (2006.01)   **H01S 3/13** (2006.01)
**H01S 5/0687** (2006.01)

(52) Cooperative Patent Classification (CPC):
**H01S 3/1305; H01S 3/082; H01S 3/1303;**
**H01S 5/0687; H01S 5/4062;** H01S 3/08013;
H01S 3/131; H01S 5/142; H01S 5/146

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Institute of Science and Technology**
**Austria**
**3400 Klosterneuburg (AT)**

(72) Inventors:
• **DIORICO, Fritz**
  **1030 Wien (AT)**
• **HOSTEN, Onur**
  **1070 Wien (AT)**

(74) Representative: **SONN Patentanwälte OG**
  **Riemergasse 14**
  **1010 Wien (AT)**

(54) **A METHOD FOR FREQUENCY LOCKING A LASER TO AN OPTICAL CAVITY**

(57) The disclosure concerns a method for frequency locking a laser (2) to an optical cavity, comprising the steps:
- providing a laser beam from the laser (2);
- shaping the laser beam such that the laser beam acquires ellipticity;
- directing the laser beam at the optical cavity (3);
- focusing a laser beam reflected from the optical cavity (3) with a detection lens (13);
- determining an error signal proportional to a beam ellipticity of the focused laser beam with a detector (15);
- locking the laser (2) to the optical cavity (3) based on the error signal;
wherein an axial distance (18) between the detection lens (13) and the detector (15) is such that when the laser (2) provides a laser beam at a resonance frequency of the optical cavity (3), a zero-crossing (19) of the error signal lies in an interval between a minimum and a maximum of the error signal, wherein the interval comprises an error signal value corresponding to a determined beam ellipticity of a substantially circular laser beam.

Fig. 1

**Description**

The disclosure concerns a method for frequency locking a laser to an optical cavity; a method for tuning a device for frequency locking a laser to an optical cavity; and a device for frequency locking a laser to an optical cavity.

Laser frequency stabilization is indispensable in the science and engineering of atomic time keeping, gravitational wave detection, tests of relativity, atom interferometry, and in the quantum control of various systems such as atoms, nanoparticles and mechanical oscillators - to name a few. As an example, contemporary atomic clocks require milliHertz-linewidth lasers to probe long-lived optical atomic transitions, and the level of precision in stabilization of laser frequencies to reference optical cavities play a crucial role in reaching the state-of-the-art performance levels. A number of methods have been developed over the decades to address the task of locking lasers to cavities. These include: side-of-fringe intensity methods, polarization based methods, frequency modulation techniques including transmission modulation and the Pound-Drever-Hall (PDH) reflection method, and lastly, spatial mode interference methods.

Certain methods could be preferable based on application, but due to its stability and versatility, the PDH technique - utilizing radio-frequency modulation/demodulation of an optical carrier - has become a general standard. Achieving the most demanding locking stabilities of 1 part in $10^5$-$10^6$ of a cavity linewidth has further required additional layers of active feedback mechanisms to reduce the residual amplitude (RAM) modulation which typically limits the lock point stability of a PDH setup. A purely passive and reduced-complexity method that could compete with these highly engineered setups could be beneficial for all applications, especially including space based ones, where electro- and acoustooptic devices used for modulation are undesirable due to power budgets and failure risk.

It is an object of the present disclosure to provide a method and device for frequency locking a laser to an optical cavity and a method for tuning such a device, which achieves a reduced complexity, is purely passive and/or achieves a good laser stabilisation, in particular is less sensitive to alignment drifts and/or comprises a more robust implementation. In particular it is an object of the present invention to propose a placement of a detection lens and a detector in such a device and method which achieves a better stabilisation.

This is achieved by a method for frequency locking a laser to an optical cavity, comprising the steps:

-    providing a laser beam from the laser;
-    shaping the laser beam such that the laser beam acquires ellipticity;
-    directing the laser beam at the optical cavity;
-    focusing a laser beam reflected from the optical cavity with a detection lens;
-    determining an error signal proportional to a beam ellipticity of the focused laser beam with a detector;
-    locking the laser to the optical cavity based on the error signal;

wherein an axial distance between the detection lens and the detector is such that when the laser provides a laser beam at a resonance frequency of the optical cavity, a zero-crossing of the error signal lies in an interval between a minimum and a maximum of the error signal, wherein the interval comprises an error signal value corresponding to a determined beam ellipticity of a substantially circular laser beam.

Further, this is achieved by a method for tuning a device for frequency locking a laser to an optical cavity, wherein the device comprises

-    a beam shaper for shaping a laser beam such that the laser beam acquires ellipticity,
-    an optical cavity for receiving the laser beam after beam shaping,
-    a detection lens for focusing a laser beam reflected from the optical cavity,
-    a detector for determining an error signal proportional to a beam ellipticity of the laser beam focused by the detection lens;

the method comprising the steps:

-    providing a laser beam at a resonance frequency of the optical cavity;
-    shaping the laser beam with the beam shaper such that the laser beam acquires ellipticity;
-    directing the laser beam at the optical cavity;
-    focusing a laser beam reflected from the optical cavity with the detection lens;
-    determining an error signal proportional to a beam ellipticity of the focused laser beam with the detector;
-    adjusting an axial distance of the detection lens and the detector along an optical axis of the laser beam such that a zero-crossing of the error signal lies in an interval between a minimum and a maximum of the error signal, wherein the interval comprises an error signal value corresponding to a determined beam ellipticity of a substantially circular laser beam.

Further, this is achieved by a device for frequency locking a laser to an optical cavity, comprising:

- a beam shaper for shaping a laser beam such that the laser beam acquires ellipticity;
- an optical cavity for receiving the laser beam after beam shaping;
- a detection lens for focusing a laser beam reflected from the optical cavity;
- a detector for determining an error signal proportional to a beam ellipticity of the laser beam focused by the detection lens;

wherein an axial distance between the detection lens and the detector is such that on providing the device, in particular the beam shaper, with a laser beam at a resonance frequency of the optical cavity, a zero-crossing of the error signal lies in an interval between a minimum and a maximum of the error signal, wherein the interval comprises an error signal value corresponding to a determined beam ellipticity of a substantially circular laser beam.

Further, the disclosure concerns a method for the production of a device for frequency locking a laser to an optical cavity, comprising the steps:

- providing a beam shaper for shaping a laser beam such that the laser beam acquires ellipticity;
- providing an optical cavity for receiving the laser beam after beam shaping;
- providing a detection lens for focusing a laser beam reflected from the optical cavity;
- providing a detector for determining an error signal proportional to a beam ellipticity of the laser beam focused by the detection lens;
- providing a laser beam at a resonance frequency of the optical cavity;
- shaping the laser beam with the beam shaper such that the laser beam acquires ellipticity;
- directing the laser beam at the optical cavity;
- focusing a laser beam reflected from the optical cavity with the detection lens;
- determining an error signal proportional to a beam ellipticity of the focused laser beam with the detector;
- adjusting an axial distance of the detection lens and the detector along an optical axis of the laser beam such that a zero-crossing of the error signal lies in an interval between a minimum and a maximum of the error signal, wherein the interval comprises an error signal value corresponding to a determined beam ellipticity of a substantially circular laser beam.

To understand the main stabilization method, the Hermite-Gaussian (HG) spatial modes supported by the optical cavity should be recalled. These are a set of Transverse Electromagnetic Modes ($TEM_{mn}$), that a cavity can support. The subscripts m and n are positive integers for each orthogonal axes in the transverse direction of beam propagation. The sum m + n is called the mode order which can either be odd or even. Starting from a perfectly aligned optical mode coming into an optical cavity, odd modes are induced by misaligning the input beam either tilting or shifting. Even modes on the other hand are induced by focusing/mode mismatch and are independent of tilting or shifting of the beam.

Earlier spatial mode interference implementations relied on inducing 1st order ($TEM_{01}$ and $TEM_{10}$) modes by tilting/misaligning the input beam. Here, of interest are the fundamental HG modes $TEM_{00}$ labeled '00', and specific second-order HG modes, 2nd order $TEM_{11}$-like modes, that we label '+', which are both even modes. Even modes are induced by mode mismatch and make our method insensitive to misalignment drifts that generate 1st order odd modes. A slightly elliptical beam with a horizontal/vertical orientation can mathematically be decomposed into a main '00' component and a small '+' component. For such a laser beam, the phase difference between these two modes encodes the information about ellipticity. If incident on the optical cavity near a '00' resonance, the two modes acquire a differential phase shift upon reflection, since only one of them resonate given that different order modes are generically non-degenerate. By way of this mechanism, the reflected beam can be made to acquire opposite ellipticities on opposite sides of the resonance of the optical cavity. To harness this effect, the ellipticity of the laser beam reflected from the optical cavity is measured after being focused.

These modes generically possess different resonance frequencies. In terms of the cavity modes, the spatial decomposition of a slightly elliptical beam that is diagonally oriented is given mostly by the $TEM_{00}$ mode with a small contribution of the '$TEM_{11}$' 2nd order mode. For such a beam, the phase difference between these two modes encodes the information about the departure from circularity. If incident on the cavity near one of its fundamental frequencies, the two modes naturally acquire a differential phase shift since only one of them resonate. This results into a shape change in the reflected beam. By way of this mechanism, the reflected beam can be made to acquire opposite ellipticities on opposite sides of the resonance, thus, generating a determinable error signal. To harness this feature, an error signal proportional to the beam ellipticity of the reflected laser beam is used and the axial distance of the detector and the detection lens has to be adjusted appropriately. By setting the axial distance such that on providing the beam shaper with a laser beam at a resonance frequency of the optical cavity, a zero-crossing of the error signal lies in an interval between a minimum and a maximum of the error signal, wherein the interval comprises an error signal value corresponding to a determined beam ellipticity of a substantially circular beam, the reflected beam acquiring opposite ellipticities on opposite sides of the resonance can be utilized to determine the laser beams deviation and/or drift, which may be used for locking and thus stabilizing the laser beam. The determined error signal can be thought of as an interference between the resonating '00' mode that leaks out of the cavity, and the second-order '+' mode that promptly reflects from the optical cavity to form a phase reference. This detection modality is insensitive to alignment drifts and fluctuations, since small misalignments simply generate first-order modes in the mode decomposition.

Under shaping the laser beam such that the laser beam acquires ellipticity is understood that the laser beam is manipulated such that subsequently the laser beam's cross-section differs from a circular cross section at at-least one point, in particular that the laser beam has differing beam waists in two transverse directions at at-least one point. Optionally, the laser beam is focused and/or diverged in at least a first plane and preferably focused and/or diverged in a second plane (not parallel to the first plane), in particular at a different point along the laser beam's path than the focusing/diverging in the first plane). The beam ellipticity may be defined according to ISO 11145:2018. Alternatively, the eccentricity may be used.

The optical cavity may be a linear cavity or a ring cavity. E.g., a ring cavity may be used where the incident and reflected beams are traveling on separate paths. The optical cavity can for example be a two-mirror cavity or a three-mirror cavity. However, a cavity with any number of mirrors and any geometry can be used. If a two-mirror (standing wave) cavity is used as the optical cavity, the reflected beam can be separated from the incident path e.g. by using a Faraday circulator or with a quarter wave plate and a polarizing beam splitter. The optical cavity may be a free-space cavity or a non-free-space cavity, such as a micro-chip-based optical cavity. E.g., the optical cavity can be a whispering gallery mode resonator, where the light circulates around the perimeter (inside the material) of a sphere or a toroid. The optical cavity could also be a fiber ring, into which light could be coupled evanescently. This coupling can for example be accomplished by using a prism, where the evanescent tails during total internal from the prism couples light in and out of the optical cavity. Thus, the prism effectively interfaces the waveguide-like structures into free space optics. The prism may look like the input mirror of a free space cavity, albeit, one with very elliptical mode structures. In this case, the input mode shaping should prepare beam profiles that are further squashed with respect to the native modes of the micro-resonator-prism assembly.

The method and device can be used with a laser beam wavelength in a wide range. E.g., the wavelength may be in the ultraviolet range, between 190 nm and 400 nm, the visible range, between 400 nm and 800 nm, in the near-infrared range, between 800 nm and 1800 nm, and/or in the infrared range, between 1800 to at least 3500nm. Optionally, the error signal is directly proportional to the beam ellipticity of the focused laser beam. Optionally, the error signal is substantially zero for a circular laser beam. Optionally, the laser is locked to the optical cavity based on the error signal by feeding the error signal back to the laser current. Optionally, the device comprises the laser. The locking is based on monitoring the change in the ellipticity of the laser beam reflected from the optical cavity.

Focusing the laser beam refers to focusing the laser beam in at least one plane. Providing a laser beam at a resonance frequency of the optical cavity preferably includes the step of tuning the laser (in particular to find the resonance frequency). Optionally, the method for tuning the device comprises (without beam shaping, i.e. prior to inserting the beam shaper into the device) :

- (perfectly) coupling the laser beam into the cavity and measuring the reflected beam properties, in particular with a CCD camera
- inserting the beam shaper into the device.

Optionally, the method for tuning the device comprises: measuring the in-plane beam waist and the out-of-plane beam waist of the laser beam reflected from the optical cavity at more than one distance.

The axial distance between the detection lens and the detector refers to their distance along the path of the laser beam. For the method and the device for frequency locking the laser to an optical cavity, the positions of the detector and the detection lens may be fixed. For the method for adjusting and producing the device, the detector and/or the detection lens may be moved. Zero-crossing refers to the error signal having a value of zero. Optionally, the minimum is a global minimum and/or the maximum is a global maximum. Optionally, there is no further extreme value between the minimum and the maximum. Optionally, the interval extends from the minimum to the maximum. In the interval comprising the error signal value corresponding to a circular laser beam (on providing a laser beam with a frequency at a resonance frequency) and between the minimum and the maximum, due to the slope of the error-signal, the error signal can be used for locking the laser. Optionally, the resonance frequency of the optical cavity is the frequency of the $TEM_{00}$ resonance or the resonance frequency of the $TEM_{02}$ or $TEM_{20}$ or $TEM_{11}$ resonance. Optionally, the axial distance may be tuned over a tuning interval to determine a curve of the error signal and to set the axial distance.

It is preferred if the detector is a quadrant photodiode and the error signal is determined by a diagonal signal of the quadrant photodiode, which diagonal signal is made up of the difference of the sums of signals from diagonal sensor regions of the quadrant photodiode. In this way, an error signal corresponding to the beam ellipticity can be achieved particularly easy. In particular, the quadrant photodiode is a photodiode with four split sensor regions. The gaps between the sensor regions may be optimized to be as small as possible. In particular, the quadrant photodiode produces electrical currents proportional to the input light from each of four sensor regions. The signal from each of the sensor regions is labeled A, B, C and D, wherein on the quadrant photodiode, the sensor regions are arranged in the order A, D, B, C (e.g. in clockwise direction). This allows the following operation: SUM = A + B + C + D, LR = (A + C) - (B + D), UD = (A + D) - (C + B), and DIAG = (A + B) - (C + D). The beam ellipticity can be measured using the DIAG operation. A zero DIAG signal indicates the lack of beam ellipticity, meaning the laser beam is circular. A non-zero DIAG signal indicates the presence of an elliptic beam on the quadrant photodiode. The quadrant photodiode may be an InGaAs-based or a silicon-based detector. The signals may be converted into voltages (e.g. using standard analog electronics with operational amplifiers).

A limitation to stability is still posed, for example, by residual fluctuations in the incident beam shape, attributable to the alteration of second-order mode components - affecting the phase reference. To help alleviate this residual limitation, a polarization pre- and post-selection procedure may be utilized, which can be described using the weak-value concept. For this purpose, optionally, the laser beam is polarization filtered prior to directing the laser beam at the optical cavity and the laser beam reflected from the optical cavity is polarization filtered. Optionally, the optical cavity is birefringent. In this way, technical noise that limits system performance can be coherently suppressed. The device preferably comprises a first polarizing beam splitter (or a first polarizer) for polarization filtering the laser beam prior to directing the laser beam to the beam shaper and a second polarizing beam splitter (or a second polarizer) for polarization filtering after emitting the laser beam from the optical cavity, in particular between the detection lens and the detector. The polarization filtering may be used in the method for frequency locking the laser and/or the method for tuning a device for frequency locking the laser.

With the polarization degree of freedom included, the cavity reflection coefficient is replaced by a reflection operator $\hat{r}$ acting on the input polarization state $|\psi1\rangle$. When a post-selection onto state $|\psi2\rangle$ is made, the resulting effective reflection coefficient $r_w$ is given by the weak-value of the reflection operator

$$r_w = \frac{\langle \psi_2 | \hat{r} | \psi_1 \rangle}{\langle \psi_2 | \psi_1 \rangle} \equiv 1 - \gamma' \frac{1}{1 - i\frac{\delta}{\kappa/2}} \qquad \text{(Equation 1)}$$

Here $\delta$ is the laser-cavity frequency detuning, $\kappa$ is the full-width cavity linewidth and $\gamma' = A\gamma$, where $\gamma$ is a dimensionless parameter characterizing the roundtrip losses in the cavity. The 'amplification' parameter A depends on the specific post-selection, and it is real-valued for linear polarization states $|\psi1\rangle$ and $|\psi2\rangle$. While it is a function of polarizer angles, operationally it can be related to the remaining power fraction $|\langle\psi2|\psi1\rangle|^2 \approx 1/(2A+1)^2$ after post-selection while the light is off-resonant. The right hand side of Equation 1 is of the same form as the reflection from a regular high-finesse cavity, except with a variable loss parameter $\gamma'$ (at fixed $\kappa$). Note that $\gamma<1$, $\gamma=1$, $\gamma>1$ and $\gamma>2$ can be identified respectively with the under-coupled, impedance-matched, over-coupled, and cavity-gain regimes. The variability of $\gamma'$ can be demonstrated experimentally by observing the post-selection dependence of the reflected power from the cavity. The error signal may be given by the imaginary part of the reflection coefficient in Equation 1. Tuning the post-selection to an impedance-matched configuration reduces noise for frequency stabilization purposes. In this configuration, the non-signal-generating beam components incident on the detector are strongly attenuated while signal generating parts are attenuated less, effectively increasing the error signal slope and reducing sensitivity to beam shape or intensity fluctuations.

Referring now to the method for tuning the device, it is preferable if adjusting an axial distance of the detection lens and the detector along an optical axis of the laser beam such that a zero-crossing of the error signal lies in an interval between a minimum and a maximum of the error signal, wherein the interval comprises an error signal value corresponding to a determined beam ellipticity of a substantially circular laser beam comprises:

adjusting the axial distance of the detection lens and the detector along an optical axis of the laser beam such that a transmission peak of the laser beam reflected from the cavity matches a zero-crossing of the error signal. The transmission peak corresponds to a reflection minimum, i.e. the SUM channel of the quadrant photodiode will give a dip (since the SUM channel of the quadrant photodiode in particular measures the reflection curve). In this way, a baseline offset of the error signal due to the optical cavity's natural astigmatism can be corrected. The baseline offset also gives rise to a shift of the transmission peak from the error signal zero-crossing. Hence, the axial QPD location can be adjusted until the transmission peak and the error signal zero-crossing match. In absence of this matching, a cross-coupling of intensity noise to frequency noise emerges. The zero-crossing or the error signal can be made to match the transmission plateau by moving the detector away or toward the detection lens or vice versa.

This position can for example be found iteratively, i.e. experimentally by fine tuning the detector's and/or detection lens' position. It is also preferable in the context of the method and the device for frequency locking the laser, if the axial distance of the detection lens and the detector along the optical axis of the laser beam is such that a transmission peak of the laser beam reflected from the cavity substantially matches or is within $\pm 5\%$ or within $\pm 2\%$ or within $\pm 1\%$ of a zero-crossing of the error signal, when the laser provides a laser beam at a resonance frequency of the optical cavity. This may also replace the feature whereby "an axial distance between the detection lens and the detector is such that when the laser provides a laser beam at a resonance frequency of the optical cavity, a zero-crossing of the error signal lies in an interval between a minimum and a maximum of the error signal, wherein the interval comprises an error signal value corresponding to a determined beam ellipticity of a substantially circular laser beam". There may be a baseline offset of the error signal. Naively and without knowledge of astimagtism, one would believe that this would not produce the best results. However, this criterion helps produce the best possible result that goes beyond that of the Pound-Drever-Hall method.

Optionally, adjusting an axial distance of the detection lens and the detector along an optical axis of the laser beam such that a zero-crossing of the error signal lies in an interval between a minimum and a maximum of the error signal, wherein the interval comprises an error signal value corresponding to a determined beam ellipticity of a substantially circular laser beam comprises:

adjusting the axial distance such that an in-plane beam waist and an out-of-plane beam waist of the laser beam reflected from the cavity match with a beam waist of a resonance cavity mode of the optical cavity (in particular with a cavity mode mean beam waist, which is the average beam waist of its in- and out-of-plane beam waist). Optionally, this is conducted prior to adjusting the axial distance of the detection lens and the detector along the optical axis of the laser beam such that the transmission peak of the laser beam reflected from the cavity matches the zero-crossing of the error signal. Optionally, additionally or alternatively, the axial distance is adjusted such that the in-plane beam waist and out-of-plane beam waist of the laser beam reflected from the cavity match (with each other). A baseline offset on the error signal is attributable to an axial displacement of the detector location from the location where the beam assumes a circular profile (disregarding astigmatism). The axial distance can be chosen such that this baseline offset is eliminated. This match of the beam waists can be used as a first approximation before matching the transmission peak and the zero-crossing or can be used itself. If there is no astigmatism, these two will give the same result. In this case there is no residual astigmatism in the modes, so zeroing the baseline automatically puts one in at the plateau of the transmission. It is also preferable in the context of the method and the device for frequency locking the laser, if the axial distance of the detector and the detection lens is such that an in-plane beam waist and an out-of-plane beam waist of the laser beam reflected from the cavity match with a beam waist of a resonance cavity mode of the optical cavity or are within $\pm 5\%$ or within $\pm 2\%$ or within $\pm 1\%$ of the beam waist of the resonance cavity mode of the optical cavity. This may also replace the feature whereby "an axial distance between the detection lens and the detector is such that when the laser provides a laser beam at a resonance frequency of the optical cavity, a zero-crossing of the error signal lies in an interval between a minimum and a maximum of the error signal, wherein the interval comprises an error signal value corresponding to a determined beam ellipticity of a substantially circular laser beam".

Optionally, the detector is a quadrant photodiode and the error signal is determined by a diagonal signal of the quadrant photodiode, which diagonal signal is made up of the difference of the sums of signals from diagonal sensor regions of the quadrant photodiode

Optionally, the method further comprises the step:

- centering the laser beam on the quadrant photodiode by translating the detection lens and/or the quadrant photodiode in the directions perpendicular to the optical axis of the laser beam such that a left-right signal and/or an up-down signal of the quadrant photodiode are minimized, which left-right (LR) signal and up-down (UD) signal are each made up of the difference of the sums of adjacent sensor regions of the quadrant photodiode, wherein the left-right signal and the up-down signal use the sums of different halves of adjacent sensor regions. Optionally, this is performed iteratively and repeatedly. In this way, the laser beam can be aligned perfectly at the quadrant photodiode, such that the best beam fit over the quadrant photodiode active area is achieved and producing the most accurate error signal. Optionally, the translation occurs in two directions, which are perpendicular to one another and to the optical axis of the laser beam.

Optionally, the step of adjusting an axial distance of the detection lens and the quadrant photodiode along an optical axis of the laser beam such that the transmission peak of the laser beam reflected from the cavity matches the zero-crossing of the error signal and the step of centering the laser beam on the quadrant photodiode are conducted iteratively (i.e. alternatively repeatedly, i.e. in turn repeatedly). For every adjustment in the axial distance, the left-right and the up-down signals can to be minimized. By repeating this process, the zero-crossing can be optimized to match exactly the transmission plateau.

Referring to all methods and device disclosed herein, it is preferable if the detection lens is a convex spherical lens.

Further, it is preferable if the laser beam is propagated in a polarizing fiber and is optionally emitted from a fiber collimator, prior to shaping the laser beam such that the laser beam acquires ellipticity. The fiber collimator may have an adjustable focus.

It is preferable, if shaping the laser beam such that the laser beam acquires ellipticity is effected at least by a pair of cylindrical lenses (which optionally which have focusing axes oriented non-parallelly, in particular perpendicularly, to each other). Optionally, the two cylindrical lenses have identical focal lengths, further optionally with one oriented horizontally and the other vertically. The focal length is optionally chosen such that if the two lenses were co-located (as if they formed one spherical lens), the incident beam would be perfectly mode matched to the $TEM_{00}$ cavity mode. The distance between the pair of cylindrical lenses may determine the amount of light in the '+' mode, which may amount to e.g. 10% of the total power (e.g. 400 pW). One cylindrical lens may be oriented with its axis in-plane and the other out-of-plane. By tuning the position of the cylindrical lenses and optionally the fiber collimator, the input mode can be engineered to induce up to 2nd order modes. They may be aligned such that all other modes but the $TEM_{00}$, the $TEM_{02}$ and the $TEM_{20}$ modes are suppressed, with an equal transmission level for the latter two. To get an equal balance of $TEM_{02}$ and $TEM_{20}$, the cylindrical lenses' positions may be set/tuned to the convergence and divergence of the in-plane and out-of-plane beam waists. The mean resonator waist is positioned exactly where the in-plane and out-of-plane beam waists match. As the beam diverges out of the cavity, its mean waist may also match the cavity mode mean waist. The balancing of the amount of $TEM_{02}$ and $TEM_{20}$ relative to $TEM_{00}$ can be tuned by the spacing between the two cylindrical lenses while keeping its center of mass constant. As each member of the pair is translated symmetrically in opposite directions from this reference configuration, the $TEM_{02}$ and $TEM_{20}$ modes are populated with equal amplitudes as observed from the cavity transmission spectrum. Physically, this action translates the beam waists for the horizontal and vertical planes to before and after the cavity waist location. Alternatively, shaping the laser beam such that the laser beam acquires ellipticity is effected by a combination of lenses, wedged prisms, and/or anamorphic prism pairs, wherein optionally an elliptical and/or astigmatic beam is created.

Referring now to the device for frequency locking a laser to an optical cavity, it is preferable if the detector is a quadrant photodiode. Optionally the detector is configured to determine the error signal by a diagonal signal of the quadrant photodiode, which diagonal signal is made up of the difference of the sums of signals from diagonal sensor regions of the quadrant photodiode.

Optionally, the beam shaper comprises a pair of cylindrical lenses, which have focusing axes oriented in non-parallel directions, in particular perpendicularly, to each other.

By way of example, the disclosure is further explained with respect to some selected embodiments shown in the drawings. However, these embodiments shall not be considered limiting for the disclosure.

Fig. 1 schematically shows an embodiment of the device for frequency locking a laser to an optical cavity.

Fig. 2a schematically shows a triangular ring cavity geometry and its relevant Hermite-Gaussian mode resonances.

Fig. 2b illustrates the beam ellipticity detection using a quadrant photodiode.

Fig. 2c illustrates the frequency dependence of the error signal.

Fig. 3 illustrates the location of the relevant elements in the beam path and the resulting beam properties in the embodiment of Fig. 1.

Fig. 4 illustrates the error signal and cavity transmission in the embodiment of Fig. 1.

Fig. 5 illustrates the error signal and the transmission.

Fig. 6 schematically illustrates an axial distance between the detection lens and the detector.

Fig. 7a illustrates the use of a first and a second polarizers in the embodiment of Fig. 1 and 8.

Fig. 7b illustrates the measured normalized reflection power for different post-selection configurations.

Fig. 7c illustrates the real and imaginary parts of the obtained weak value.

Fig. 8 illustrates two copies of the lockup setup, which was used to demonstrate the performance of the stabilization scheme.

Fig. 9a illustrates the locking instability over averaging time of the experimental setup shown in Fig. 8 in comparison to other stabilization methods.

Fig. 9b shows a comparison of the achieved instability for operation with and without post-selection and at the bottom the corresponding beatnote time traces.

Fig. 9c shows estimated limitations to stability.

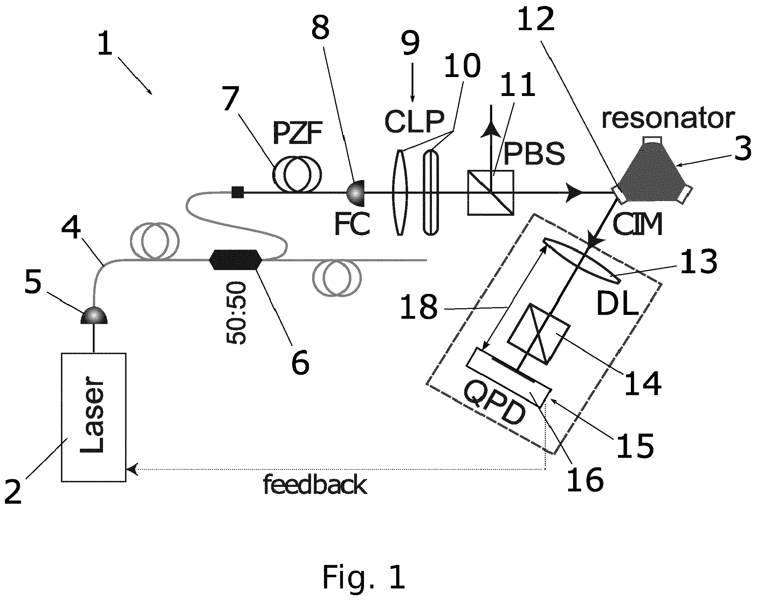

Fig 1. schematically shows an embodiment of the device 1 for frequency locking a laser 2 to an optical cavity 3. In this embodiment, the device 1 comprises the laser 2 and the optical cavity 3 is formed as a three-mirror optical cavity. A laser beam from the laser 2 is coupled into a polarizing fibre 4 at input collimator 5. The optical fibre 4 comprises a 50:50 polarization maintaining fiber splitter 6, wherein one of the outputs of the fiber splitter 6 may be used as the "useful" light. Further, there is provided for a polarizing fiber (PZF) 7 and a fiber collimator 8 for emitting the laser beam from the polarizing fiber 4. The emitted laser beam is directed at the beam shaper 9 for shaping the laser beam such that the laser beam acquires ellipticity. In this embodiment, the beam shaper 9 comprises a pair of cylindrical lenses (CLP) 10, which have focusing axes oriented perpendicularly to each other. Subsequently, the laser beam is subjected to a first polarizing beam splitter (PBS) 11, which is rotatable.

The laser beam is subsequently directed at the cavity input mirror 12 of the optical cavity 3. The laser beam reflected from the optical cavity 3 is directed at the detection lens (DL) 13, which may be a (e.g. 100 mm) convex spherical lens. The detection lens 13 is for focusing the laser beam reflected from the optical cavity 3. Subsequently, the laser beam passes a second polarizing beam splitter 14. The device 1 further comprises a detector 15 for determining an error signal proportional to a beam ellipticity of the laser beam focused by the detection lens 13. In this embodiment, the detector 15 is a quadrant photodiode 16, wherein the detector 15 is configured to determine the error signal based on a diagonal signal of the quadrant photodiode 16, which diagonal signal is made up of the difference of the sums of signals from diagonal sensor regions of the quadrant photodiode 16.

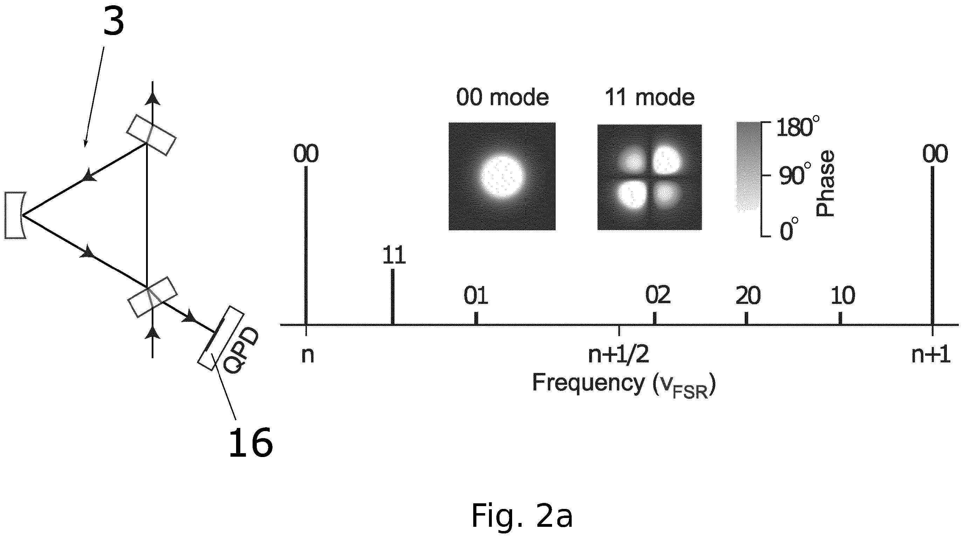

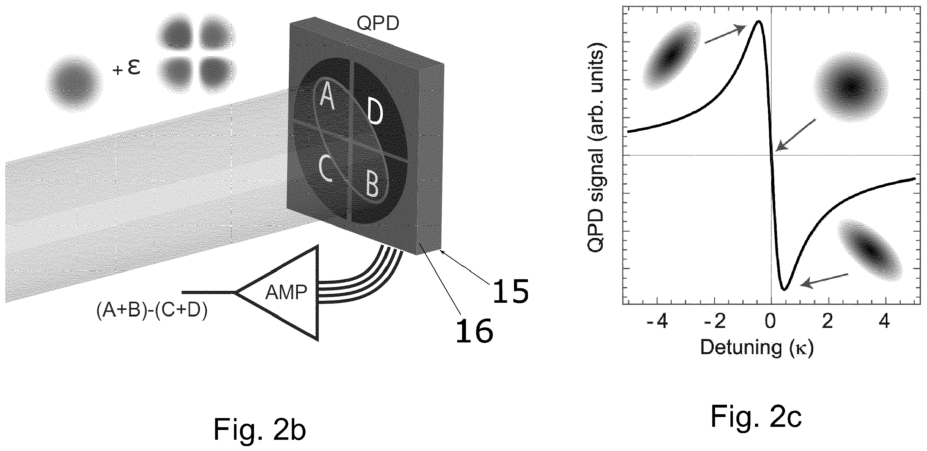

Figs. 2a, 2b and 2c conceptually illustrate the error signal generation based on which the laser can be locked (indicated by the dotted line in Fig. 1 indicating the use of the error signal as feedback for locking the laser, e.g. by adjusting the laser current).

Fig. 2a schematically shows a triangular ring cavity geometry and its relevant Hermite-Gaussian mode resonances. In this embodiment, the optical cavity 3 comprises two plane mirrors and one (e.g. 5 cm radius-of-curvature) convex mirror. Further, the spatial amplitude structure of the '00' and the '+' modes are illustrated in the inset. In terms of the native cavity modes, the '+' mode appears as a superposition of the '02' and '20' modes. Alignment drifts populate the '01' and '10' modes. Therein, $\nu_{FSR}$ represents the free spectral range and n represents an integer. In this example, the cavity parameters may be: 7.01 cm round trip length, $\nu_{FSR}$=4.28 GHz, finesse of 195 for the '00' mode.

Fig. 2b illustrates the beam ellipticity detection using a quadrant photodiode and the mode decomposition of a slightly elliptical beam, wherein $\varepsilon$ is a small complex number. As can be seen from Fig. 2b, the DIAG=(A+B)-(C+D) function of the quadrant photodiode 16 gives the beam ellipticity. Further, the error signal is generated with a transimpedance filter (AMP).

Fig. 2c illustrates the frequency dependence of the error signal for light reflected from the cavity near the '00' mode resonance, wherein $\kappa$ is the cavity full-linewidth.

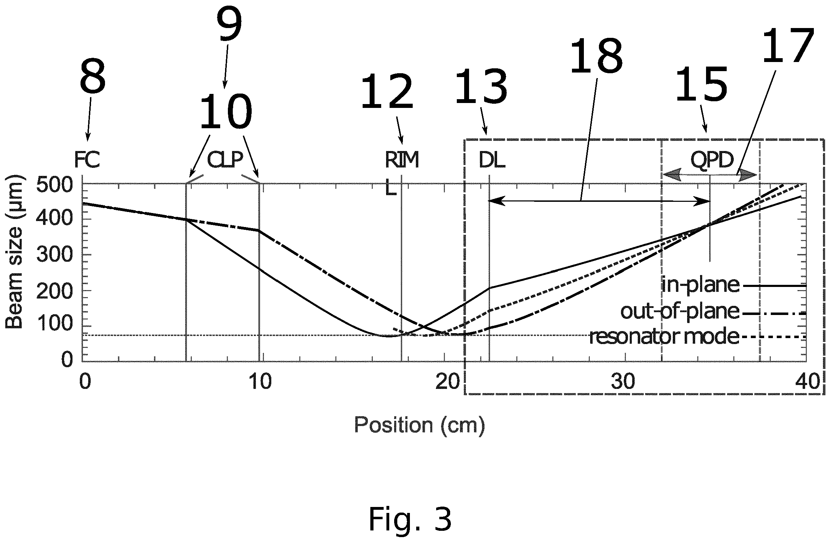

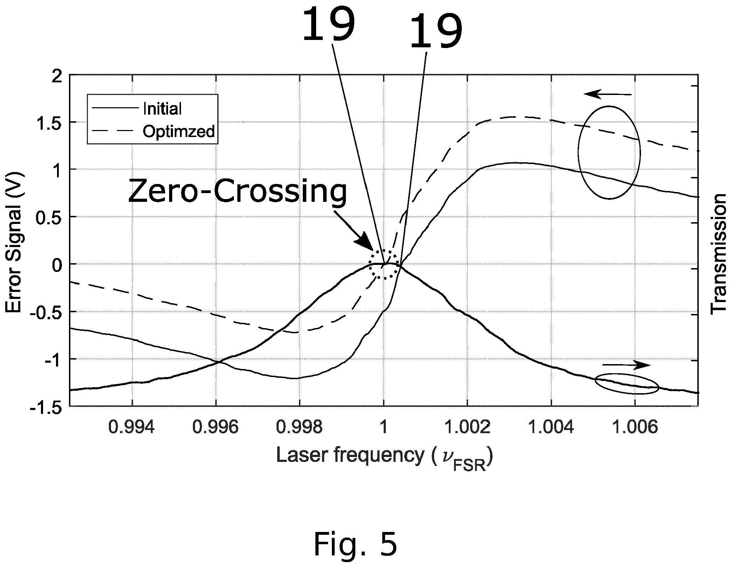

The positioning of the detection lens 13 and the detector 15 will subsequently be explained in the context of Figs. 3 and 5.

Fig. 3 illustrates the location of the relevant elements in the laser beam path and the resulting beam properties, in particular beam waists in-plane and out-of-plane and the resonator mode beam waist, in the embodiment of Fig. 1. In particular, a configuration of the optical elements that excite the $TEM_{02}$ and $TEM_{20}$ modes at about 5% relative to the peak power of the $TEM_{00}$ mode is shown. Prior to reaching the beam shaper 9 with the pair of cylindrical lenses 10, the laser beam's beam waists in-plane and out-of-plane match. As can be seen, the beam shaper 9 imposes an ellipticity on the laser beam. At the detection lens 13, the laser beam is focused. The detector 15 is shown in the position were the in-plane and out of plane beam waists match the resonator mode beam waist. The mean cavity mode waist may be at 74 $\mu$m, the in-plane beam waist at 84 $\mu$m and the out-of-plane beam waist at 65 $\mu$m. Further, the tuning interval 17 is shown, within which the axial distance 18 of the detector lens 13 and the detector 15 can be adjusted in order to use the error signal for frequency locking the laser. The dimensions in the figures (e.g. of the position in cm in Fig. 3) are only chosen for illustrational purposes and may also take on different values.

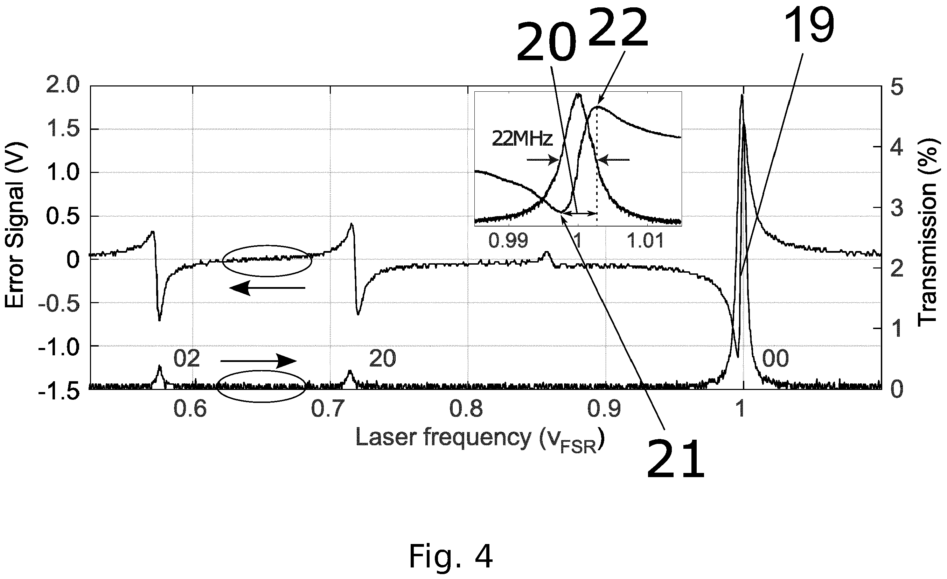

Fig. 4 illustrates the error signal and cavity transmission in the embodiment of Fig. 1. The axial distance 18 is adjusted such a zero-crossing 19 of the error signal lies within an interval 20 between a minimum 21 and a maximum 22 of the error signal, such that an error signal value corresponding to a determined beam ellipticity of a substantially circular laser beam - when the laser provides a laser beam at the resonance frequency of the cavity - is within the interval 20. The interval 20 in terms of the frequency translated into the tuning interval 17 of the axial distance 18. The error signal shown in Fig. 4 can be used to lock the laser 2 to the optical cavity 3.

A second laser system could also be locked on the opposite side of the optical cavity 3, mirror the left side. In principle, with this three-mirror cavity, up to three lasers can be locked simultaneously. This can be scaled up by increasing the mirror count. Alternatively if the laser wavelengths are sufficiently different, multiple lasers can be locked using the same input mirror, provided the beams for each wavelength are separated with filters afterwards.

Fig. 5 illustrates the error signal and the transmission. Even though the background offset is zero or minimized when the in-plane and out-of-plane beam waists match exactly with the cavity mode beam waist, the error signal's zero crossing 19 does not exactly correspond to the plateau of the transmission peak of the optical cavity 3, as can be seen in Fig. 5. Therefore, it is even further preferred if the axial distance 18 of the detection lens 13 and the detector 15 is adjusted such that the transmission peak of the laser beam reflected from the optical cavity 3 matches a zero crossing 19 of the error signal. Fig. 5 shows the error signal with the beam waists matched ("initial") and with the transmission peak and the zero-crossing 19 matched ("optimized") .

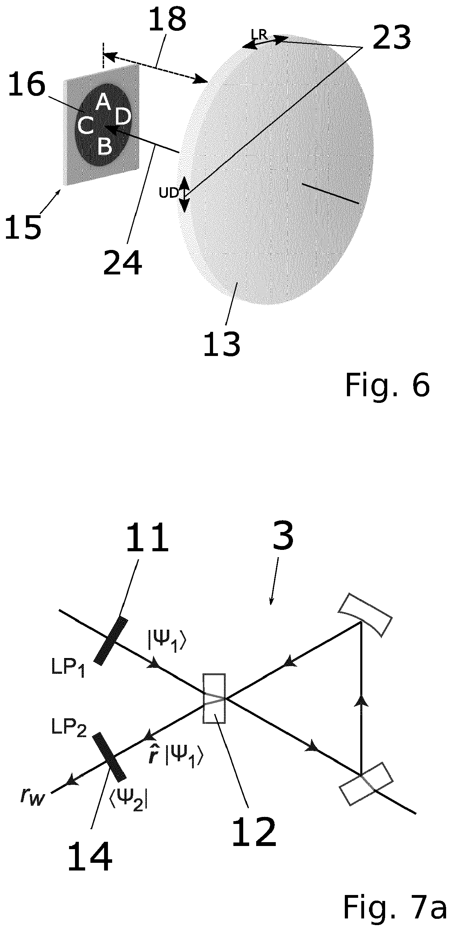

Fig. 6 schematically illustrates the axial distance 18 between the detection lens 13 and the detector 18. The laser beam can also be centered on the detector 18. This is achieved by translating the detection lens 13 (and/or the detector 15) in the directions 23 ("LR", i.e. left-right, and "UD", i.e. up-down) perpendicular to the optical axis 24 such that a left-right signal and an up-down signal of the quadrant photodiode 16 are minimized. The left-right signal LR = (A + C) - (B + D) and the up-down signal UD = (A + D) - (C + B) are each made up of the difference of the sums of adjacent sensor regions of the quadrant photodiode 16, wherein the left-right signal and the up-down signal use the sums of different halves of adjacent sensor regions. It is preferable, if the laser beam is re-centered when the axial distance 18 is adjusted. Therefore, it is preferable if these steps are conducted repeatable and iteratively. I.e., for every adjustment of the axial distance 18, the LR and UD signals should be minimized again. By repeating this process, the zero crossing 19 is optimized to match exactly the transmission plateau, as is shown for the "optimized" error signal in Fig. 5.

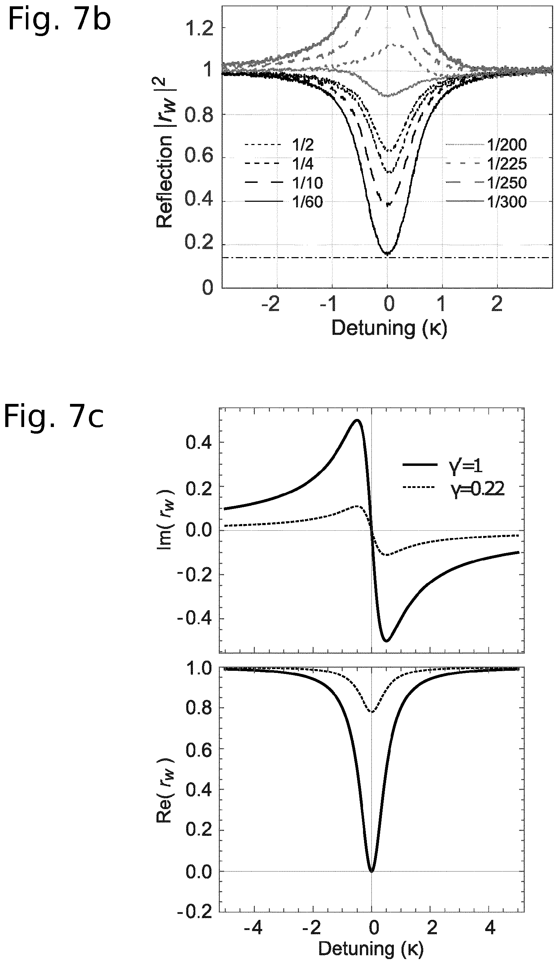

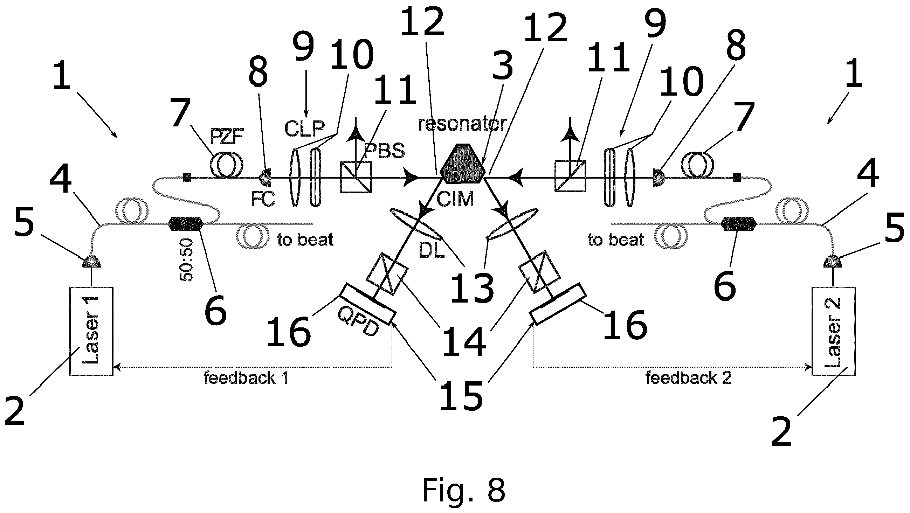

Figs. 7a to 7c illustrate the weak value enhancement, i.e. the effective cavity under polarization pre- and post-selection. In particular, Fig. 7a illustrates the use of a first and a second polarizers in the embodiments of Fig. 1 and of Fig. 8 described below. An input polarizer 11 and an output polarizer 14 is used to obtain the weak-value $r_W$ of the reflection operator $\hat{r}$, resulting in an effective cavity with a tunable reflection. The polarizers 11, 14 are both linear polarizers. Thus, the laser beam is polarization filtered prior to being directed at the optical cavity 3 and the laser beam reflected from the optical cavity is also polarization filtered. Fig. 7b illustrates the measured normalized reflection power for different post-selection configurations. Curves are labelled by their off-resonant remaining power fraction $|\langle\psi 2|\psi 1\rangle|^2$. The 1/2 -curve is the same as the original cavity reflection curve; the 1/60 curve is the impedance matched ($\gamma'$=1) configuration. The dash-dot lines represent intensity contribution levels from the non-'00'-mode components. Fig. 7c shows the real and imaginary part of $R_W$ for an input mode matched to the '00' mode (in theory), illustrating the advantages of post-selection: An effective increase in the slope of the error signal and a minimization of optical power on the detector 15 near the locking point is achieved.

Fig. 8 illustrates two copies of the lockup setup, which was used to demonstrate the performance of the stabilization scheme. The two copies share the same optical cavity 3 and apart from that each comprises (on its own) the same elements as the device 1 described in the context of Fig. 1. Therefore, reference is made to the description of Fig. 1 and the same elements are indicated by the same reference numerals. Two separate lasers 2 were stabilized to two degenerate counter-propagating '00' modes of the triangular ring cavity 3. The distance between the pair of cylindrical lenses 10 determines the amount of light in the '+' mode, which amounts to around 10% of the total power (about 400 $\mu$W) used in the experiment. A comparison between different optical frequency stabilization systems can be achieved by characterizing the performance as a fractional instability with respect to the cavity linewidth - nominally, absolute instabilities will scale proportional to the cavity linewidth since typical sources of problematic instabilities originate from fluctuations in the error signal shape. In this experiment, a 22-MHz full-linewidth cavity was employed and two external cavity diode lasers at 780 nm with 500 kHz intrinsic-linewidths.

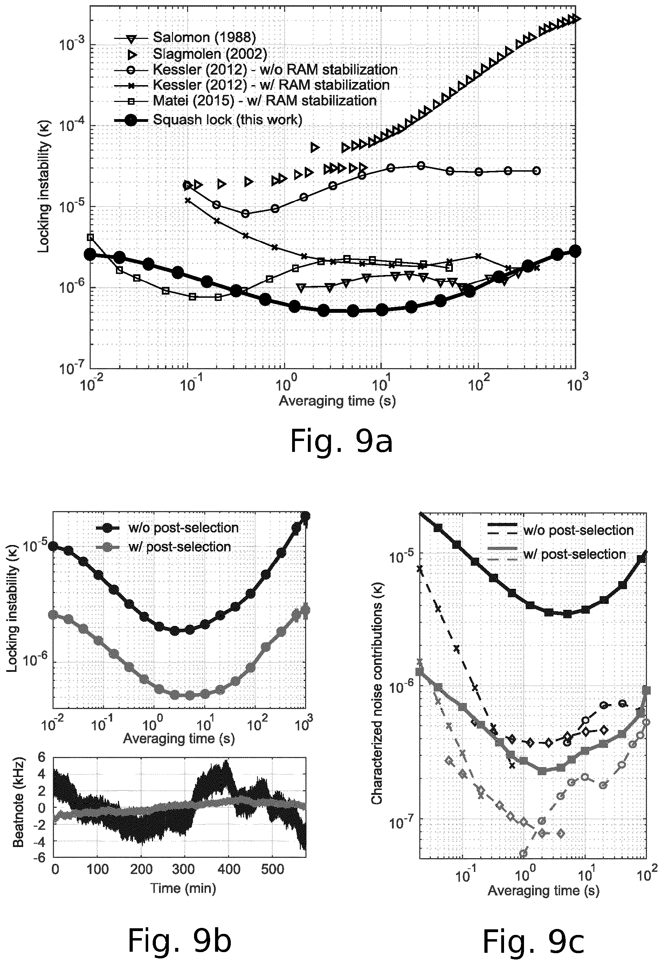

Fig. 9a illustrates the locking instability over averaging time of the experimental setup shown in Fig. 8 in comparison to other stabilization methods. The performance of the implemented scheme while locked to a '00' mode resonance is shown. The $10^{-7}$ locking instability regime is reached for averaging times between 0.25 s and 100 s, surpassing previous state-of-the-art, and reaching $5 \times 10^{-7}$ instability at 10 s averaging time. The Allan deviation of a 10-hour recorded beatnote is taken and equal instabilities for the two locks are assumed. The comparison is conducted with respect to the following methods:

-   Salomon (Salomon, C., Hils, D. & Hall, J. L. Laser stabilization at the millihertz level. J. Opt. Soc. Am. B 5, 1576 (1988).): transmission modulation method;

- Slagmolen (Slagmolen, B. J. J., Shaddock, D. A., Gray, M. B. & McClelland, D. E. Frequency stability of spatial mode interference (tilt) locking. IEEE J. Quantum Electron. 38, 1521-1528 (2002).): double-passed 'tilt locking' method;
- Matei (Matei, D. G. et al. 1.5 μ m Lasers with Sub-10 mHz Linewidth. Phys. Rev. Lett. 118, 263202 (2017).): PDH method;
- Kessler (Kessler, T. et al. A sub-40-mHz-linewidth laser based on a silicon single-crystal optical cavity. Nat. Photonics 6, 687-692 (2012).): PDH method out-of-loop noise floor characterization with and without RAM stabilization (arXiv:1112.3854 for this data).

Data were extracted and expressed relative to cavity linewidths utilized in each work.

Fig. 9b shows at the top a comparison of the achieved instability for operation with and without post-selection and at the bottom the corresponding beatnote traces.

Fig. 9c shows estimated limitations to stability of an operation with post-selection, an operation without post-selection, with the dominant contribution due to beam shape noise in solid lines and the subdominant contribution in dashed lines. The break-down of the subdominant contributions is as follows: measured in-loop error signal noise (crosses), detector 15 dark noise (diamonds) and laser 2 intensity drift noise (circles).

The experiment conducted with the setup shown in Fig. 8 is now described in more detail. It is noted, however, that different parameters may be used as well and this should not be considered limiting to the invention.

The optical cavity 3 is made of one high reflectivity curved mirror (5 cm radius of curvature) and two lower reflectivity (-98.93 for p-polarization at 30° angle of incidence) plane mirrors. The reflectivities are chosen to make the cavity linewidth larger than those of the lasers 2 (500 kHz) for simplicity. The mirrors are attached with an epoxy resin on an aluminum block with three drilled bores that form a nearly equilateral triangle. The fiber collimator 8 and pair of cylindrical lenses 10 forming the beam shaper 9 are mounted on a cage assembly, which is situated on a 5-axis tip-tilt-translation stage. This assembly, together with the axial translation capability of the fiber collimator lens makes it easy to mode match to the optical cavity 3. The optical cavity 3, together with the remaining optics are all mounted directly onto the optical table, and are enclosed with a metal box for temperature and air fluctuation stability. The aluminum cavity spacer is temperature stabilized to within 1mK to control the cavity length.

To experimentally identify the cavity mode reference profile (cf. also Fig. 3), light is back coupled to the '00' mode from one of the mirrors and the mode profile emitted out of the cavity 3 (along the path to the quadrant photodiode (QPD) 16) is characterized with a CMOS camera. Incident beam profile is adjusted by tuning the location of the optical elements to match the reference mode upon reflection from the cavity. Once aligned, all other modes but the '00' and the '02'-'20' are suppressed, with an equal transmission level for the latter two.

Following the input light alignment, the QPD 16 location is aligned. For centering the beam on the QPD 16, the detection lens (DL) 13 is translated while monitoring the left-right and up-down signals from the QPD 16. With the beam centered, a baseline offset on the error signal is attributable to an axial displacement of the QPD 16 location from the location where the beam assumes a circular profile. The QPD 16 location can in principle be adjusted to eliminate this offset. However, the natural astigmatism of the cavity 3 also contributes to the baseline offset. This also gives rise to a shift of the transmission peak from the error signal zero-crossing 19. Hence the axial QPD 16 location can be adjusted until the transmission peak and the error signal zero-crossing 19 matches. In absence of this matching, a cross-coupling of intensity noise to frequency noise emerges.

The electronic backend:

The QPD 16 and the feedback circuits are home built. All quadrants of the QPD 16 are independently amplified with a 380 kOhm transimpedance gain, and arithmetic operations are then carried out with operational amplifier circuits to simultaneously access the diagonal, left-right, up-down and sum signals. These respectively give us the cavity lock error signal, the beam centering signals and the total light intensity reflecting from the cavity.

The signal from the diagonal channel goes to an analog feedback circuit and is fed to the laser current to keep the lasers 2 on resonance with the cavity when locked. The feedback loop contains two integrators ($1/f^2$ response) from DC to 20 kHz, and a single integrator ($1/f$ response) from 20 kHz to the lock bandwidth of 100 kHz, providing a lock tightness that does not pose a dominant limitation to stability (crosses in Figure 9c). All input and output signals to the feedback circuits are differential in order to eliminate ground loops, which is crucial to performance.

We note that the QPD 16 together with the implemented amplification circuit operates shot-noise limited for frequencies larger than 300 Hz. Below this frequency amplifier noise starts taking over. However the observed locking stability for timescales larger than 10 ms is not related either to shot noise or to amplifier noise, and this is typical for other experiments operating in such timescales.

System performance, comparison and noise characterization:

Assuming equal performances for the two copies of the laser-cavity locking setup, the actual instability for one of the copies is given by $1/\sqrt{2}$ of the measured laser beatnote instability since the independent noises add in quadrature. This correction is already taken into account in Figure 9, and is a standard procedure. This in general provides a conservative estimate of achievable instability, since if one of the two setups were to perform better, extracting the performance of that setup would require dividing with an even larger number. In our case, the performance of any of the two copies is roughly equal, since the characterized beam shape noise which limits the performance turned out to be the same for both copies.

For comparison with previous state-of-the-art, we extracted instability data from the works cited in Figure 9 (see below) using WebPlotDigitizer, and scale the data to represent fractions relative to cavity linewidths utilized in each work. In choosing specific publications for comparison, we payed particular attention to works involving more than one similar setup to obtain a real measured stability through a laser beatnote. Note that, one can try to infer a locking stability from a single copy of the system by recording the in-loop error signal and utilizing an appropriate conversion factor. This method is not necessarily reliable since a feedback loop suppresses the error signal irrespective of its physical origin. For example, the in-loop error signal in our work continues to average into the $10^{-8}$ instability scale, but the real stability limitation is brought by the deviation of the error signal from the actual frequency value due to beam shape noise. Among the comparison data, the 'Slagmolen' and 'Salomon' curves, together with the results presented in this work are obtained by locking two lasers to the same cavity, whereas the 'Matei' curve is obtained by comparing two lasers locked to separate cavities - and is limited by the thermal noise of the utilized cavities.

The estimated limitations to stability presented in Figure 9c (see below) were carried out ex situ. The beam shape noise was measured by physically blocking the cavity mode, so that no light builds up inside the cavity. In this configuration, the input mirror promptly directs the incident light to the QPD and allows one to characterize the beam ellipticity fluctuations in the incident beam. No further modelling was done to take into account any shape noise filtering effects that the cavity might perform while the mode is not blocked. The QPD dark noise was measured by blocking the incident light and monitoring the error signal. The intensity drift noise was measured by simultaneously monitoring the laser beatnote frequency and the sum channels of the QPDs 16 while the lasers 2 were locked to the cavity 3. Except for the intensity noise, the on-resonance error signal slope was used to convert the measurements to frequency. For the intensity drift noise, the measured laser intensity dependence of the beatnote in locked operation was used. We note that there is no active intensity stabilization in this work.

It was verified that the stability limitation indeed comes from beam ellipticity fluctuations and not indirectly from beam pointing fluctuations combined with non-idealities in the QPD detection system. By translating the QPD position perpendicular to the beam axis, a cross-talk isolation between the beam position and beam ellipticity signals in excess of a factor of 200 was observed. On the other hand, the voltage noise in the beam position signals during operation are only one order of magnitude larger than that in the ellipticity signals, ruling out the beam pointing cross-talk as the dominating noise source.

A narrower laser linewidth would in principle improve stability in the short time scales, assuming there are no other dominating sources of defection noise in the system. In our case, artificially broadening the laser linewidth from 500 kHz to 1 MHz (by injecting current noise) did not deteriorate the performance, suggesting that the linewidth is not the limitation. We also note that there is no laser linewidth narrowing induced in our parameter regime, since the lock bandwidth (100 kHz) is smaller than the initial laser linewidth. An advantage of the locking method investigated in this work in comparison to the next-best 'transmission modulation' method (Fig. 9a) is its use of the reflected beam - a property also shared with the PDH method. In this mode of operation, lock bandwidth is not directly limited by the cavity linewidth. This is important in the context of narrow linewidth high finesse cavities, when one tries to narrow the linewidth of a laser in addition to stabilizing its central frequency.

As an additional note, the fundamental limits of many frequency locking techniques due to optical shot noise have been shown to be the same to within a numerical factor of order unity, and our method is no exception.

Advantages of post-selection: In addition to the already-discussed suppression of sensitivity to intensity noise and incident beam shape fluctuations, the post-selection reduces sensitivity to beam pointing fluctuations. Although these fluctuations affect the signal in the diagonal QPD channel only to second order, and do not appear to cause a limitation in the current work, they are nevertheless further reduced. Another non-ideality that the post-selection suppresses is an adverse effect of the astigmatism of the triangular cavity modes. The astigmatism causes the zero-crossings of the error signal to become offset from the transmission intensity maxima. This results in reduced performance through intensity-to-frequency noise conversion. One can mitigate this effect by fine tuning alignment as discussed in the alignment procedures, nonetheless, the post-selection significantly suppresses these problems, rendering alignments easier.

Qualitatively, the improvements brought by the post-selection can be thought of as originating from a differential measurement performed on two beams with orthogonal polarizations - one that goes into the cavity and one that is promptly reflected from the cavity. Through post-selection, this differential measurement is manifested as a coherent process which improves the slope of the error signal (making it more sensitive to smaller frequency shifts) for a fixed amount of light impinging on the QPD. The post-selection process improves performance as long as the resulting intensity on the QPD does not fall below an equivalent electronic noise floor.

Alongside all improvements, the post-selection is also observed to introduce a small sensitivity of frequency lock point to cavity length changes. Preliminarily characterizations suggest that this increased sensitivity is likely due to polarization changes in the light reflecting from the cavity as the light frequency changes - effectively changing the post-selection angle. Neverthe less cavity length is a parameter that is necessarily well controlled in frequency stabilization applications, and it does not pose a dominant limitation in our implementation.

Application to different cavity geometries:
In Fig. 1 and 8, a ring cavity is utilized where the incident and reflected beams are traveling on separate paths. For different applications, different cavity designs might be required. For example, ultralow-vibration sensitivity typically requires working with two-mirror standing wave cavities. For this configuration nothing changes regarding the main method: Although the reflected beam travels on the same path as the incident beam, it can easily be separated, e.g., using a quarter-wave plate together with a polarizing beam splitter (as is usually done for the PDH method). Also note that the specific mode spectrum of a cavity does not play a role in the implementation; the only requirement for proper operation is for the $TEM_{00}$ mode not to be spectrally degenerate with the second-order modes, and thus the second order modes can have arbitrary generic resonance frequencies. The main method can also be used with waveguide-like cavities which require evanescent coupling, e.g., with dielectric whispering gallery mode cavities, or fiber rings. A well established coupling strategy is the use of a prism, where the evanescent tails from the prism during total internal reflection couple light in-and-out of the cavity. The prism thus effectively interfaces waveguide-like structures into free space optics, and it appears like an input mirror of a free-space cavity for the purposes of applying the methods developed here.

Post selected beam evolution and the weak value of the reflection coefficient:
Here we outline the derivation of the effective reflection coefficient and related formulas used above. First, we model the cavity reflection without the polarization degree of freedom in the quantum mechanical language used for describing weak-values, then we take into account the polarization.

In the first case, there are two degrees of freedom in the problem: the 'mode shape' and the 'channel'. The states spanned by the first are the various TEM modes, and the states spanned by the second are the labels 'incident' ($|\mathcal{I}\rangle$), 'reflected' ($|\mathcal{R}\rangle$) and 'transmitted' ($|\mathcal{T}\rangle$). We take the initial state as a direct product state for the two degrees of freedom: $|\Psi\rangle=|\Phi\rangle\otimes|\mathcal{I}\rangle$. Here, the state 'Φ' stands for an arbitrary input mode shape. To phenomenologically describe reflection from the cavity near the '00' resonance, we define a unitary operator $\hat{U}=|0\rangle\langle0|\otimes\hat{U}_c+(\hat{I}-|0\rangle\langle0|\otimes(|\mathcal{I}\rangle\langle\mathcal{R}|+|\mathcal{R}\rangle\langle\mathcal{I}|)$ which evolves the state of the 'channel' with another unitary operator $\hat{U}_C$ if the 'mode shape' is in state $|0\rangle$, and evolves the incident state $|\mathcal{I}\rangle$ directly into the reflected state $|\mathcal{R}\rangle$ otherwise. Here $\hat{I}$ is the identity operator for the 'mode shape' degree of freedom, and $|0\rangle\langle0|$ is the projection operator for the '00' mode. If we are only interested in the reflected part of the beam, an effective evolution operator $\hat{R}$ that acts only on the input 'mode shape' state $|\Phi\rangle$ can be defined using a projection onto the reflected part after the state evolution: $\hat{R}|\Phi\rangle=\langle\mathcal{R}|\hat{U}|\Phi\rangle|\mathcal{I}\rangle$. This procedure yields the effective evolution operator $\hat{R}=r|0\rangle\langle0|+(I-|0\rangle\langle0|)$ with $r=\langle\mathcal{R}|U_c|\mathcal{I}\rangle$ being the amplitude reflection coefficient - an experimentally determined quantity.

Now, inclusion of the polarization degree of freedom introduces a more general unitary operator that evolves the initial state $|\Psi\rangle=|\psi_1\rangle\otimes|\Phi\rangle\otimes|I\rangle$. Here $|\psi_1\rangle$ is the initial state of the polarization degree of freedom. Using the above procedure, an effective evolution operator $\hat{R}=\hat{R}_H+\hat{R}_V$ acting only on the initial 'mode shape' and 'polarization' state $|\psi_1\rangle\otimes|\Phi\rangle$ can be deduced, yielding $\hat{R}_H=|H\rangle\langle H|\otimes(r_H|0\rangle\langle0|+(I-|0\rangle\langle0|))$ and $\hat{R}_v=|V\rangle\langle V|\otimes e^{i\phi}(r_v|0\rangle\langle0|+(I-|0\rangle\langle0|))$. In these expressions, $r_H$ and $r_V$ are the amplitude reflection coefficients for the horizontal $|H\rangle$ and vertical $|V\rangle$ polarization states - corresponding to the principal axes of the cavity. Here, a potential relative birefringent phase shift Φ is explicitly included for the prompt reflection from an angled cavity input mirror. A further projection onto the polarization state $|\psi'_2\rangle$ using the definition $\hat{R}_{post}|\Phi\rangle=\langle\psi'_2|R|\Phi\rangle|\psi_1\rangle$, yields the final post-selected evolution operator $\hat{R}_{post}=\langle\psi_2|\psi_1\rangle[r_w|0\rangle\langle0|+(I-|0\rangle\langle0|)]$, which acts purely on the input mode state $|\Phi\rangle$. Here, $r_w=\langle\psi_2|\hat{r}|\psi_1\rangle/\langle\psi_2|\psi_1\rangle$ is the weak-value of the reflection operator $\hat{r}=r_H|H\rangle\langle H|+r_v|V\rangle\langle V|$, and the overlap coefficient $\langle\psi_2|\psi_1\rangle$ in $\hat{R}_{post}$ further signifies the lossy nature of the post-selection operation. Note that for clarity, we have absorbed the effect of the birefringent phase shift into the definition of the post-selected state: $|\psi_2\rangle=(|H\rangle\langle H|+|V\rangle\langle V|e^{-i\Phi})|\psi'_2\rangle$. Above, the small birefringent phase is ignored, but the residual asymmetry of the curves in Fig. 7b can be attributed to it.

Now we will evaluate $r_w$ for our experimental configuration. With the use of linear polarizers, the pre- and post-selected states can be written as $|\psi_1\rangle=\cos\theta_1|H\rangle+\sin\theta_1|V\rangle$ and $|\psi_2\rangle=\cos\theta_2|H\rangle+e^{-i\Phi}\sin\theta_2|V\rangle$. This results into $r_w=r_H(½+B)+r_V(½-B)$ for the weak-value, and $\langle\psi_2|\psi1\rangle=\cos(\theta_2+\theta_1)/(B+½+e^{-i\Phi}(B-½))$ for the overlap coefficient. Here we defined the complex number $B=(1+e^{-i\Phi}\tan\theta_2\tan\theta_1)^{-1}-½$. For the present work the cavity is polarization resolving, and we can take the vertical polarization component to be far off-resonance, and use $r_H=1-\gamma/(1-i\frac{\delta}{\kappa/2})$ and $r_V=1$ with $\gamma$, $\delta$ and $\kappa$ as defined in the main text. This results into the weak value $r_w = 1 - \gamma (B + \tfrac{1}{2}) / (1 - i\frac{\delta}{\kappa/2})$. Lastly, we will make the small-birefringent-phase approximation $\Phi \ll 1$ and expand in a power series in $\Phi$ to reach the formulas used in the main text. We obtain

$$r_w = 1 - \gamma' \frac{1}{1 - i\frac{\delta}{\kappa/2}} \qquad (2)$$

$$\langle \psi_f | \psi_i \rangle = e^{-i\phi(A-1)} \left( \frac{1}{2A-1} + \frac{A(A-1)}{2A-1} \frac{\phi^2}{2} \right) \cos(\theta_2 + \theta_1) \qquad (3)$$

where $\gamma' = A\gamma e^{-i\Phi(A-1)}$ and $A = \tfrac{1}{2} + B|_{\Phi=0}$. The successful post-selection probability can be written as

$$|\langle \psi_f | \psi_i \rangle|^2 \approx \frac{1}{(2A-1)^2} + \frac{A(A-1)}{(2A-1)^2} \phi^2 \quad ,$$

where we assumed $\cos(\theta_2 + \theta_1)^2 \sim 1$ for the relevant post-selection angles. The expressions used above further set $\Phi = 0$.

**Claims**

1. A method for frequency locking a laser (2) to an optical cavity, comprising the steps:

   - providing a laser beam from the laser (2);
   - shaping the laser beam such that the laser beam acquires ellipticity;
   - directing the laser beam at the optical cavity (3);
   - focusing a laser beam reflected from the optical cavity (3) with a detection lens (13);
   - determining an error signal proportional to a beam ellipticity of the focused laser beam with a detector (15);
   - locking the laser (2) to the optical cavity (3) based on the error signal;

   wherein an axial distance (18) between the detection lens (13) and the detector (15) is such that when the laser (2) provides a laser beam at a resonance frequency of the optical cavity (3), a zero-crossing (19) of the error signal lies in an interval between a minimum and a maximum of the error signal, wherein the interval comprises an error signal value corresponding to a determined beam ellipticity of a substantially circular laser beam.

2. The method according to claim 1, wherein the detector (15) is a quadrant photodiode (16) and the error signal is determined by a diagonal signal of the quadrant photodiode (16), which diagonal signal is made up of the difference of the sums of signals from diagonal sensor regions of the quadrant photodiode (16) .

3. A method for tuning a device for frequency locking a laser (2) to an optical cavity (3), wherein the device comprises

   - a beam shaper for shaping a laser beam such that the laser beam acquires ellipticity,
   - an optical cavity (3) for receiving the laser beam after beam shaping,
   - a detection lens (13) for focusing a laser beam reflected from the optical cavity (3),
   - a detector (15) for determining an error signal proportional to a beam ellipticity of the laser beam focused by the detection lens (13);

   the method comprising the steps:

   - providing a laser beam at a resonance frequency of the optical cavity (3);
   - shaping the laser beam with the beam shaper such that the laser beam acquires ellipticity;
   - directing the laser beam at the optical cavity (3);
   - focusing a laser beam reflected from the optical cavity (3) with the detection lens (13);
   - determining an error signal proportional to a beam ellipticity of the focused laser beam with the detector (15);

- adjusting an axial distance (18) of the detection lens (13) and the detector (15) along an optical axis (24) of the laser beam such that a zero-crossing (19) of the error signal lies in an interval (20) between a minimum (21) and a maximum (22) of the error signal, wherein the interval (20) comprises an error signal value corresponding to a determined beam ellipticity of a substantially circular laser beam.

4.  The method according to claim 3, wherein adjusting the axial distance (18) of the detection lens (13) and the detector (15) comprises:
    adjusting the axial distance (18) of the detection lens (13) and the detector (15) along an optical axis (24) of the laser beam such that a transmission peak of the laser beam reflected from the optical cavity (3) matches a zero-crossing (19) of the error signal.

5.  The method according to claim 3 or 4, wherein adjusting the axial distance (18) of the detection lens (13) and the detector (15) comprises, optionally prior to adjusting the axial distance (18) of the detection lens (13) and the detector (15) along the optical axis (24) of the laser beam such that the transmission peak of the laser beam reflected from the optical cavity (3) matches the zero-crossing (19) of the error signal:
    adjusting the axial distance (18) such that an in-plane beam waist and an out-of-plane beam waist of the laser beam reflected from the optical cavity (3) match with a beam waist of a resonance cavity mode of the optical cavity (3).

6.  The method according to any one of claims 3 to 5, wherein the detector (15) is a quadrant photodiode (16) and the error signal is determined by a diagonal signal of the quadrant photodiode (16), which diagonal signal is made up of the difference of the sums of signals from diagonal sensor regions of the quadrant photodiode (16).

7.  The method according to claim 6, further comprising the step:

    - centering the laser beam on the quadrant photodiode (16) by translating the detection lens (13) and/or the quadrant photodiode (16) in the directions (23) perpendicular to the optical axis (24) of the laser beam such that a left-right signal and/or an up-down signal of the quadrant photodiode (16) are minimized, which left-right signal and up-down signal are each made up of the difference of the sums of adjacent sensor regions of the quadrant photodiode (16), wherein the left-right signal and the up-down signal use the sums of different halves of adjacent sensor regions.

8.  The method according to claim 7, wherein the step of adjusting an axial distance (18) of the detection lens (13) and the quadrant photodiode (16) along the optical axis (24) of the laser beam such that the transmission peak of the laser beam reflected from the optical cavity (3) matches the zero-crossing (19) of the error signal and the step of centering the laser beam on the quadrant photodiode (16) are conducted iteratively.

9.  The method according to any one of the previous claims, wherein the detection lens (13) is a convex spherical lens.

10. The method according to any one of the previous claims, wherein the laser beam is propagated in a polarizing fiber (4) and is optionally emitted from a fiber collimator (8), prior to shaping the laser beam such that the laser beam acquires ellipticity.

11. The method according to any one of the previous claims, wherein shaping the laser beam such that the laser beam acquires ellipticity is effected by a pair of cylindrical lenses (10), which have focusing axes oriented non-parallelly, in particular perpendicularly, to each other and/or shaping the laser beam such that the laser beam acquires ellipticity is effected by a combination of lenses, wedged prisms, and/or anamorphic prism pairs, wherein an elliptical or astigmatic beam is created.

12. The method according to any one of the previous claims, wherein the laser beam is polarization filtered prior to directing the laser beam at the optical cavity (3) and the laser beam reflected from the optical cavity (3) is polarization filtered, wherein optionally the optical cavity (3) is birefringent.

13. A device for frequency locking a laser (2) to an optical cavity (3), comprising:

    - a beam shaper (9) for shaping a laser beam such that the laser beam acquires ellipticity;
    - an optical cavity (3) for receiving the laser beam after beam shaping;
    - a detection lens (13) for focusing a laser beam reflected from the optical cavity (3);
    - a detector (15) for determining an error signal proportional to a beam ellipticity of the laser beam focused by the detection lens (13);

wherein an axial distance (18) between the detection lens (13) and the detector (15) is such that on providing the beam shaper (9) with a laser beam at a resonance frequency of the optical cavity (3), a zero-crossing (19) of the error signal lies in an interval (20) between a minimum (21) and a maximum (22) of the error signal, wherein the interval (20) comprises an error signal value corresponding to a determined beam ellipticity of a substantially circular laser beam.

14. The device according to claim 13, wherein the detector (15) is a quadrant photodiode (16),
wherein optionally the detector (15) is configured to determine the error signal by a diagonal signal of the quadrant photodiode (16), which diagonal signal is made up of the difference of the sums of signals from diagonal sensor regions of the quadrant photodiode (16).

15. The device according to any of claims 13 or 14, wherein the beam shaper (9) comprises a pair of cylindrical lenses (10), which have focusing axes oriented non-parallelly, in particular perpendicularly, to each other.

Fig. 1

Fig. 2a

EP 4 203 206 A1

Fig. 2b

Fig. 2c

EP 4 203 206 A1

Fig. 3

EP 4 203 206 A1

Fig. 4

Fig. 5

Fig. 6

Fig. 7a

Fig. 7b

Fig. 7c

Fig. 8

Fig. 9a

Fig. 9b

Fig. 9c

Europäisches
Patentamt

European
Patent Office

Office européen
des brevets

# EUROPEAN SEARCH REPORT

Application Number

EP 21 21 6871

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GAGLIARDI G ET AL: "Interrogation of fiber Bragg-grating resonators by polarization- spectroscopy laser-frequency locking", ADVANCES IN MULTIMEDIA INFORMATION PROCESSING - PCM 2002. PCM 2002. LECTURE NOTES IN COMPUTER SCIENCE, SPRINGER, BERLIN, HEIDELBERG. DE, vol. 15, no. 7, 2 April 2007 (2007-04-02), pages 3715-3728, XP002453608, DOI: 10.1364/OE.15.003715 | 1,9-13, 15 | INV. H01S3/082 H01S3/13 H01S5/0687 |
| A | * page 3717, lines 1-21; figures 3-5 * * page 3722 - page 3725 * ----- | 2-8,14 | |
| A | HANSCH T W ET AL: "Laser frequency stabilization by polarization spectroscopy of a reflecting reference cavity", OPTICS COMMUNICATIONS, ELSEVIER, AMSTERDAM, NL, vol. 35, no. 3, 1 December 1980 (1980-12-01), pages 441-444, XP024445742, ISSN: 0030-4018, DOI: 10.1016/0030-4018(80)90069-3 [retrieved on 1980-12-01] * page 442, paragraph 2; figure 2 * ----- | 1,3,13 | TECHNICAL FIELDS SEARCHED (IPC) H01S |
| A | US 5 134 622 A (DEACON DAVID A G [US]) 28 July 1992 (1992-07-28) * column 4, lines 6-50; figures 1,4 * * column 11, lines 35-54 * ----- -/-- | 1,3,13 | |

The present search report has been drawn up for all claims

| Place of search | Date of completion of the search | Examiner |
|---|---|---|
| The Hague | 3 June 2022 | Claessen, Michiel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Europäisches Patentamt
European Patent Office
Office européen des brevets

Application Number

EP 21 21 6871

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HAHTELA O ET AL: "Position measurement of a cavity mirror using polarization spectroscopy; Position measurement of a cavity mirror using polarization spectroscopy", JOURNAL OF OPTICS. A, PURE AND APPLIED OPTICS, INSTITUTE OF PHYSICS PUBLISHING, BRISTOL, GB, vol. 6, no. 3, 1 March 2004 (2004-03-01), pages S115-S120, XP020081390, ISSN: 1464-4258, DOI: 10.1088/1464-4258/6/3/019 * page 8117, column 3, last paragraph; figure 3 * | 1,3,13 | |
| A | US 2015/070692 A1 (ADLER FLORIAN [US]) 12 March 2015 (2015-03-12) * paragraph [0061] * | 1,3,13 | |
| T | FRITZ DIORICO ET AL: "Laser-cavity locking at the 10^-7 instability scale utilizing beam elipticity", ARXIV.ORG, CORNELL UNIVERSITY LIBRARY, 201 OLIN LIBRARY CORNELL UNIVERSITY ITHACA, NY 14853, 9 March 2022 (2022-03-09), XP091178696, * the whole document * | 1-15 | TECHNICAL FIELDS SEARCHED (IPC) |

The present search report has been drawn up for all claims

| Place of search | Date of completion of the search | Examiner |
|---|---|---|
| The Hague | 3 June 2022 | Claessen, Michiel |

## ANNEX TO THE EUROPEAN SEARCH REPORT
## ON EUROPEAN PATENT APPLICATION NO.

EP 21 21 6871

This annex lists the patent family members relating to the patent documents cited in the above-mentioned European search report.
The members are as contained in the European Patent Office EDP file on
The European Patent Office is in no way liable for these particulars which are merely given for the purpose of information.

03-06-2022

| Patent document cited in search report | | Publication date | Patent family member(s) | | | Publication date |
|---|---|---|---|---|---|---|
| US 5134622 | A | 28-07-1992 | NONE | | | |
| US 2015070692 | A1 | 12-03-2015 | TW | 201518696 | A | 16-05-2015 |
| | | | US | 2015070692 | A1 | 12-03-2015 |
| | | | WO | 2015038561 | A1 | 19-03-2015 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SALOMON, C. ; HILS, D. ; HALL, J. L.** Laser stabilization at the millihertz level. *J. Opt. Soc. Am.,* 1988, vol. 5, 1576
- **SLAGMOLEN, B. J. J. ; SHADDOCK, D. A. ; GRAY, M. B. ; MCCLELLAND, D. E.** Frequency stability of spatial mode interference (tilt) locking. *IEEE J. Quantum Electron.,* 2002, vol. 38, 1521-1528

- **MATEI, D. G. et al.** 1.5 $\mu$ m Lasers with Sub-10 mHz Linewidth. *Phys. Rev. Lett.,* 2017, vol. 118, 263202
- **KESSLER, T et al.** A sub-40-mHz-linewidth laser based on a silicon single-crystal optical cavity. *Nat. Photonics,* 2012, vol. 6, 687-692